# EUROPÄISCHE PATENTSCHRIFT

(11) **EP 4 449 135 B1**
(45) Veröffentlichungstag und Bekanntmachung des Hinweises auf die Patenterteilung: **17.09.2025**
(21) Anmeldenummer: 22809055.1
(22) Anmeldetag: 24.10.2022
(51) Int. Cl.: H02J 7/00, G01R 31/00, H02J 1/08

(54) **VERSORGUNGSSCHALTUNG MIT EINER RECHNEREINRICHTUNG ZUR DIAGNOSE EINER VERBINDUNGSSCHALTUNG, INSBESONDERE FÜR EINE LEISTUNGSELEKTRONIK IN EINEM FAHRZEUG, UND VERFAHREN FÜR DEN BETRIEB EINER VERSORGUNGSSCHALTUNG MIT EINER RECHNEREINRICHTUNG ZUR DIAGNOSE EINER VERBINDUNGSSCHALTUNG**
SUPPLY CIRCUIT HAVING A COMPUTER DEVICE FOR DIAGNOSING A CONNECTING CIRCUIT, IN PARTICULAR FOR POWER ELECTRONICS IN A VEHICLE, AND METHOD FOR OPERATING A SUPPLY CIRCUIT HAVING A COMPUTER DEVICE FOR DIAGNOSING A CONNECTING CIRCUIT
CIRCUIT D'ALIMENTATION COMPRENANT UN DISPOSITIF INFORMATIQUE POUR DIAGNOSTIQUER UN CIRCUIT DE CONNEXION, EN PARTICULIER POUR L'ÉLECTRONIQUE DE PUISSANCE DANS UN VÉHICULE, ET PROCÉDÉ POUR FAIRE FONCTIONNER UN CIRCUIT D'ALIMENTATION COMPRENANT UN DISPOSITIF INFORMATIQUE POUR DIAGNOSTIQUER UN CIRCUIT DE CONNEXION

(30) Priorität: 16.12.2021 DE 102021214483
(43) Veröffentlichungstag der Anmeldung: 23.10.2024
(73) Patentinhaber: Robert Bosch GmbH, 70442 Stuttgart (DE)
(72) Erfinder: HAAS, Axel, 71720 Oberstenfeld (DE)
(86) Internationale Anmeldenummer: PCT/EP2022/079569
(87) Internationale Veröffentlichungsnummer: WO 2023/110202

(56) Entgegenhaltungen:
- DE-A1- 102007 035 061
- DE-A1- 102019 112 706
- DE-A1- 102019 127 798

## Beschreibung

Die Erfindung betrifft eine Versorgungsschaltung mit einer Rechnereinrichtung zur Diagnose einer Verbindungsschaltung und ein Verfahren für den Betrieb einer Versorgungsschaltung mit einer Rechnereinrichtung zur Diagnose einer Verbindungsschaltung. Ferner betrifft die Erfindung einen Antriebsstrang mit einer Versorgungsschaltung, ein Fahrzeug mit einem Antriebsstrang sowie ein Computerprogramm und ein computerlesbares Medium.

### Stand der Technik

Die Druckschrift DE 10 2019 112706 A1 offenbart eine Versorgungsschaltung mit einer ersten und zweiten Versorgungsquelle. Eine Vielzahl an Steuergeräten sind in Fahrzeugen eingebaut zur Steuerung unterschiedlichster Funktionen, beispielsweise zur Steuerung eines Antriebsmotors, einer Bremse, einer Lenkung oder zur Steuerung von Komfortfunktion wie die Klimatisierung und Sitzverstellung. Diese Steuergeräte werden zur Versorgung mit elektrischer Energie an dem Bordnetz eines Fahrzeugs angeschlossen. Dieses Bordnetz weist gewöhnlich eine Spannung von 12 Volt auf. Die Steuergeräte steuern jedoch unterschiedliche Schaltungen oder Verbraucher an, die weitere Betriebsspannungen aufweisen, beispielsweise 5 Volt für eine Recheneinheit, 15 Volt für eine Ansteuerung von Schaltelementen, 20 Volt für hydraulische Komponenten. Daher gibt es innerhalb der Steuergeräte Versorgungsschaltungen, die die Spannung aus dem Bordnetz in die gewünschte Betriebsspannung oder Versorgungsspannung wandeln. Für sicherheitsrelevante Funktionen oder Verbraucher werden diese Versorgungsschaltungen u. a. redundant, also mit mehreren Versorgungsquellen, aufgebaut. Ein Verbraucher kann folglich parallel von zwei

Versorgungsquellen versorgt werden. So wird eine zuverlässige Spannungsversorgung gewährleistet. Weiter besteht die Möglichkeit, bei Auftreten eines einzelnen Fehlers, den Verbraucher mit der redundanten Versorgungsquelle sicher weiter zu betreiben und den Verbraucher oder ein den Verbraucher umgebendes System, bevorzugt aus mehreren Steuergeräten, in einen sicheren Zustand zu bringen. Anschließend kann der Fehler behoben werden. So wird für den erneuten Betrieb eine sichere, zuverlässige Spannungsversorgung gewährleistet. Es ist bekannt, derartige redundante Versorgungsschaltungen mittels zweier Versorgungsquellen aufzubauen. Häufig umfasst eine Versorgungsquelle mindestens zwei Schaltnetzteile zur Bereitstellung von mindestens zwei Betriebsspannungen oder Versorgungsspannungen. So werden mehrere Schaltungen oder Verbraucher, die unterschiedliche Betriebsspannungen aufweisen, versorgt. Für den redundanten Betrieb der Versorgungsquellen sind die jeweils gleich großen Versorgungsspannungen parallel geschaltet. Ein Fehler, wie zum Beispiel ein Kurzschluss einer Versorgungsspannung zu einem anderen Potential oder Masse, würde einen hohen Strom zur Folge haben. Dieser hohe Stromfluss führt zum Zusammenbrechen aller der von den Versorgungsquellen bereitgestellten Versorgungsspannungen. Daher besteht der Bedarf an Lösungen, die einen derartigen Fehler erkennen können und in einem solchen Fall einen weiteren sicheren Betrieb mindestens einer der Versorgungsquellen ermöglicht. Darüber hinaus muss die Betriebsbereitschaft einer solchen Lösung stets gegeben sein. Daher muss eine entsprechende Lösung überwachbar und deren Funktionsfähigkeit diagnostizierbar sein.

### Offenbarung der Erfindung

Es wird eine Versorgungsschaltung mit einer Rechnereinrichtung zur Diagnose einer Verbindungsschaltung bereitgestellt, insbesondere für eine Leistungselektronik in einem Fahrzeug. Die Versorgungsschaltung umfasst mindestens eine erste und eine zweite Versorgungsquelle zur Versorgung mindestens eines ersten und mindestens eines zweiten Verbrauchers. Die erste Versorgungsquelle ist dazu eingerichtet, nach einem Einschalten der ersten Versorgungsquelle eine erste Versorgungsspannung für den ersten Verbraucher bereitzustellen und eine dritte Versorgungsspannung für die Verbindungsschaltung bereitzustellen, wobei die dritte Versorgungsspannung mittels der Verbindungsschaltung auch dem zweiten Verbraucher bereitstellbar ist. Die zweite Versorgungsquelle ist dazu eingerichtet, nach dem Einschalten der zweiten Versorgungsquelle eine zweite Versorgungsspannung für den zweiten Verbraucher bereitzustellen. Die Verbindungsschaltung ist dazu eingerichtet, mittels Schließen eines Schaltelementes die dritte Versorgungsspannung mit dem zweiten Verbraucher elektrisch zu verbinden und mittels Öffnen des Schaltelementes die dritte Versorgungsspannung von dem zweiten Verbraucher zu trennen. Die Versorgungsschaltung umfasst eine Rechnereinrichtung. Die Rechnereinrichtung ist dazu eingerichtet, eine anliegende zweite Versorgungsspannung am zweiten Verbraucher zu ermitteln und die bestimmungsgemäße Funktion der Verbindungsschaltung in Abhängigkeit der ermittelten anliegenden zweiten Versorgungsspannung zu diagnostizieren.

Bevorzugt ist eine Leistungselektronik in einem Fahrzeug ein Spannungswandler. Bevorzugt ist ein Spannungswandler in ein Wechselrichter oder ein Gleichspannungswandler. Bevorzugt dient der Wechselrichter der Wandlung der Gleichspannung einer Batterie in eine mehrphasige Spannung zur Versorgung einer elektrischen Maschine, die bevorzugt zum Antrieb des Fahrzeugs eingerichtet ist. Bevorzugt dient ein Gleichspannungswandler der Wandlung der Hochspannung der Batterie eines Fahrzeugs in die Betriebsspannung des Bordnetz des Fahrzeugs oder umgekehrt. Bevorzugt dient ein Gleichspannungswandler in einem Ladegerät eines Fahrzeugs der Anpassung der Ladespannung an die Batteriespannung der zu ladenden Batterie.

Bevorzugt ist die Rechnereinrichtung der Versorgungsschaltung eine Steuereinrichtung, ein Mikrokontroller oder ein Regler, die dazu eingerichtet ist, Daten, Signale oder Informationen mindestens eines Verbrauchers zu empfangen und bevorzugt an mindestens einen der Verbraucher zu übermitteln. Bevorzugt ist die Rechnereinrichtung dazu eingerichtet, eine erste oder zweite Versorgungsquelle einzuschalten. Bevorzugt umfasst das Einschalten einer Versorgungsquelle das eingangsseitige Verbinden der Versorgungsquelle mit einem Versorgungsnetz, bevorzugt einem Versorgungsnetz eines elektrischen Systems oder einem Bordnetz eines Fahrzeugs. Bevorzugt umfasst eine Versorgungsquelle mindestens ein Schaltnetzteil oder einen Gleichspannungswandler, der eine Eingangsspannung in eine Ausgangsspannung umwandelt und als eine Versorgungsspannung an Ausgangsanschlüssen bereitstellt. Bevorzugt umfasst eine Versorgungsquelle ein erstes und ein zweites Schaltnetzteil oder einen ersten und einen zweiten Gleichspannungswandler zur Bereitstellung einer ersten und einer zweiten Versorgungsspannung. Bevorzugt sind die Ausgangsanschlüsse eines Schaltnetzteils oder eines Gleichspannungswandlers über Anschlussleitungen galvanisch mit den Eingangsanschlüssen eines Verbrauchers verbunden. Bevorzugt bedeutet das Bereitstellen einer Versorgungsspannung für einen Verbraucher, dass nach dem Einschalten der Versorgungsquelle die Versorgungsspannung über die Anschlussleitungen dem Verbraucher bereitgestellt wird und folglich an den Eingangsanschlüssen des Verbrauchers anliegt. Bevorzugt ist die dritte Versorgungsspannung mittels der Verbindungsschaltung auch dem zweiten Verbraucher bereitstellbar, indem ein Schaltelement in der Verbindungsschaltung geschlossen wird und die dritte Versorgungsspannung durch die Verbindungsschaltung über Anschlussleitungen zwischen der Verbindungsschaltung und dem zweiten Verbraucher diesem bereitgestellt wird. Bevorzugt sind die Anschlussleitungen zwischen der Verbindungsschaltung und dem zweiten Verbraucher und die Anschlussleitungen zwischen der zweiten Versorgungsquelle und dem zweiten Verbraucher zusammen, bevorzugt parallel, geschaltet. Bevorzugt wird so eine Versorgung des zweiten Verbrauchers sowohl mittels der ersten als auch mittels der zweiten Versorgungsquelle ermöglicht. Bevorzugt erfolgt das Verbinden der dritten Versorgungsspannung mit dem zweiten Verbraucher mittels Schließen eines Schaltelementes, indem die Anschlussleitungen zwischen der ersten Versorgungsquelle der dritten Versorgungsspannung und der Verbindungsschaltung mit den Anschlussleitungen zwischen der Verbindungsschaltung und dem zweiten Verbraucher elektrisch verbunden werden. Bevorzugt erfolgt das Trennen der dritten Versorgungsspannung von dem zweiten Verbraucher mittels Öffnen des Schaltelementes, indem die Anschlussleitungen zwischen der ersten Versorgungsquelle der dritten Versorgungsspannung und der Verbindungsschaltung von den Anschlussleitungen zwischen der Verbindungsschaltung und dem zweiten Verbraucher elektrisch getrennt werden. Bevorzugt erfolgt das Trennen, wenn ein Kurzschluss der zweiten Versorgungsspannung vorliegt, bevorzugt nach Masse oder einem anderen Potential. Bevorzugt ermittelt die Rechnereinrichtung eine anliegende zweite Versorgungsspannung am zweiten Verbraucher, indem sie Daten, Informationen oder Signale bzgl. der anliegenden zweiten Versorgungsspannungen von dem zweiten Verbraucher übermittelt bekommt. Bevorzugt umfasst hierzu der zweite Verbraucher eine Spannungsmesseinrichtung zur Erfassung der anliegenden zweiten Versorgungsspannung. Bevorzugt übermittelt der zweite Verbraucher die ermittelte anliegende zweite Versorgungsspannung als Daten, Informationen oder als ein Signal an die Rechnereinheit. Bevorzugt interpretiert die Rechnereinrichtung keine an dem zweiten Verbraucher anliegende zweite Versorgungsspannung, wenn die Rechnereinrichtung keine Daten oder Informationen des zweiten Verbrauchers empfängt. Alternativ umfasst die Rechnereinrichtung eine Spannungsmesseinrichtung, um die anliegende zweite Versorgungsspannungen an dem zweiten Verbraucher zu ermitteln. Bevorzugt diagnostiziert die Rechnereinrichtung die bestimmungsgemäße Funktion der Verbindungsschaltung in Abhängigkeit der ermittelten anliegenden zweiten Versorgungsspannung, indem eine Differenz einer ermittelten anliegenden zweiten Versorgungsspannung zu einem ersten Zeitpunkt und einer ermittelten anliegenden zweiten Versorgungsspannung zu einem zweiten Zeitpunkt gebildet und ausgewertet wird oder indem Zeitpunkte verglichen werden, zu denen eine ermittelte anliegenden zweite Versorgungsspannung einen ersten Spannungswert aufweist und zu dem eine ermittelte anliegenden zweite Versorgungsspannung einen zweiten Spannungswert aufweist oder indem eine Kombination der Informationen ausgewertet wird. Bevorzugt diagnostiziert die Rechnereinrichtung einen Defekt der Verbindungsschaltung, wenn die Differenz einen vorgebbaren Differenzschwellwert unterschreitet, oder wenn sich über eine Zeitdauer, die einen vorgebbaren Zeitdauerwert überschreitet, die ermittelte anliegende zweite Versorgungsspannung nicht ändert. Bevorzugt wird der Betrieb der ersten Versorgungsquelle oder der Versorgungsschaltung eingestellt, wenn ein Defekt diagnostiziert wird. Vorteilhaft wird eine Versorgungsschaltung bereitgestellt, die eine Diagnose einer Verbindungsschaltung ermöglicht. Bevorzugt wird hierzu keine direkte oder physikalische Verbindung zwischen der Rechnereinheit und der Verbindungsschaltung benötigt. Dies ermöglicht eine besonders einfache Umsetzung einer Versorgungsschaltung mit einer Rechnereinrichtung zur Diagnose einer Verbindungsschaltung in einem Steuergerät.

In einer anderen Ausgestaltung der Erfindung ist das Schaltelement der Verbindungsschaltung geöffnet ist, solange die dritte Versorgungsspannung nicht an der Verbindungsschaltung anliegt.

Das Schaltelement der Verbindungsschaltung ist bevorzugt ein elektronisch anzusteuernder Schalter, der automatisch öffnet, solange die die dritte Versorgungsspannung nicht an der Verbindungsschaltung anliegt. Bevorzugt trennt somit die Verbindungsschaltung die erste Versorgungsquelle von dem zweiten Verbraucher solange keine dritte Versorgungsspannung der Verbindungsschaltung bereitgestellt wird. Vorteilhaft wird eine Versorgungsschaltung bereitgestellt, bei der im ausgeschalteten Zustand der zweite Verbraucher galvanisch von der Versorgungsschaltung getrennt ist.

In einer anderen Ausgestaltung der Erfindung umfasst die Verbindungsschaltung eine Schaltverzögerungseinrichtung und ist dazu eingerichtet, das Schaltelement nach einer vorgebbaren ersten Zeitdauer zu schließen, nachdem die dritte Versorgungsspannung an der Verbindungsschaltung anliegt.

Bevorzug ist die Schaltverzögerungseinrichtung mittels einer Software oder einer Hardware dazu eingerichtet, das Schaltelement nach einer vorgebbaren ersten Zeitdauer zu schließen, nachdem die dritte Versorgungsspannung an der Verbindungsschaltung anliegt. Bevorzugt beträgt die vorgebbare erste Zeitdauer ungefähr 0,1 bis 1 Sekunde. Vorteilhaft wird ein Verhalten der Verbindungsschaltung bereitgestellt, welches vorteilhaft eine verbesserte Diagnose der Verbindungsschaltung durch die Rechnereinheit ermöglicht.

In einer anderen Ausgestaltung der Erfindung ist die Rechnereinrichtung dazu eingerichtet, die erste Versorgungsquelle einzuschalten und die bestimmungsgemäße Funktion der Verbindungsschaltung zu diagnostizieren, wenn bei Ablauf einer vorgebbaren Einschaltdauer nach dem Einschalten der ersten Versorgungsquelle die zweite anliegende Versorgungsspannung einem zweiten vorgebbaren Spanungswert entspricht und nach anschließendem Ablauf der ersten Zeitdauer die zweite anliegende Versorgungsspannung einem dritten vorgebbaren Spanungswert.

Bevorzugt stellt nach Ablauf einer vorgebbaren Einschaltdauer nach dem Einschalten der ersten Versorgungsquelle die erste Versorgungsquelle eine dritte Versorgungsspannung für die Verbindungsschaltung bereit. Bevorzugt beträgt die vorgebbare Einschaltdauer ungefähr 0,1 bis 1 Sekunde. Bevorzugt dauert das Bereitstellen der dritten Versorgungsspannung für die Verbindungsschaltung solange wie die vorgebbare Einschaltdauer. Bevorzugt entspricht der zweite Spannungswert Null Volt. Aufgrund der Schaltverzögerung unmittelbar nach dem Bereitstellen der dritten Versorgungsspannung für die Verbindungsschaltung liegt aufgrund des geöffneten Schalters die dritte Versorgungsspannung zunächst nicht an dem zweiten Verbraucher an. Bevorzugt beträgt die zweite anliegende Versorgungsspannung am zweiten Verbraucher daher Null Volt, wenn der Schalter bestimmungsgemäß geöffnet ist. Aufgrund der Schaltverzögerung beträgt bevorzugt anschließend nach Verstreichen der ersten Zeitdauer die zweite anliegende Versorgungspannung einem dritten Spannungswert, wobei dieser bevorzugt der dritten Versorgungsspannung entspricht, die mittels geschlossenem Schalter der Verbindungsschaltung nun dem zweiten Verbraucher bereitgestellt wird. Bevorzugt wird ein Defekt diagnostiziert, wenn die anliegende zweite Versorgungsspannung von den vorgegebenen Spannungswerten abweichen. Bevorzugt wird ein Defekt diagnostiziert, wenn bereits nach Ablauf der vorgebbaren Einschaltdauer nach Einschalten der ersten Versorgungsquelle die zweite anliegende Versorgungsspannung dem dritten Spannungswert oder nach anschließendem Verstreichen der ersten Zeitdauer die zweite anliegende Versorgungspannung dem zweiten Spannungswert entspricht. Bevorzugt wird der Betrieb der ersten Versorgungsquelle oder der Versorgungsschaltung eingestellt, wenn ein Defekt diagnostiziert wird. Vorteilhaft wird eine Versorgungsschaltung bereitgestellt, die eine verbesserte Diagnose der Verbindungsschaltung ermöglicht. Bevorzugt wird eine Diagnose bereitgestellt, die die bestimmungsgemäße Funktion des Schaltelementes sicherstellt. Bevorzugt ist die bestimmungsgemäße Funktion des Schaltelementes, dass es öffnet, wenn die dritte Versorgungsspannung nicht für die Verbindungsschaltung bereitgestellt ist oder solange die erste Zeitdauer der Schaltverzögerungseinrichtung noch nicht verstrichen ist.

In einer anderen Ausgestaltung der Erfindung ist die Rechnereinrichtung dazu eingerichtet, eine anliegende erste Versorgungsspannung am ersten Verbraucher zu ermitteln, und die bestimmungsgemäße Funktion der Verbindungsschaltung in Abhängigkeit der ermittelten anliegenden ersten und zweiten Versorgungsspannung zu diagnostizieren.

Bevorzugt ermittelt die Rechnereinrichtung eine anliegende erste Versorgungsspannung am ersten Verbraucher und eine anliegende zweite Versorgungsspannung am zweiten Verbraucher, indem sie Daten, Informationen oder Signale bzgl. der anliegenden Versorgungsspannungen von den Verbrauchern übermittelt bekommt. Bevorzugt ermittelt die Rechnereinrichtung eine anliegende erste Versorgungsspannung am ersten Verbraucher oder eine anliegende zweite Versorgungsspannung am zweiten Verbraucher, indem der Empfang von Daten, Informationen oder Signalen des jeweiligen Verbrauchers als ein Vorhandensein der jeweiligen anliegenden Versorgungsspannung gewertet wird. Bevorzugt umfassen die Verbraucher Spannungsmesseinrichtungen zur Erfassung der anliegenden Versorgungsspannungen und übermitteln diese als Daten, Informationen oder Signale an die Rechnereinrichtung. Bevorzugt übermitteln die Verbraucher die ermittelten anliegenden Versorgungsspannungen als Daten, Informationen oder als ein Signal an die Rechnereinheit. Bevorzugt interpretiert die Rechnereinrichtung keine an dem Verbraucher anliegende Versorgungsspannung, wenn die Rechnereinrichtung keine Daten oder Informationen des Verbrauchers empfängt. Alternativ umfasst die Rechnereinrichtung Spannungsmesseinrichtungen, um die anliegenden Versorgungsspannungen an den Verbrauchern zu ermitteln. Bevorzugt diagnostiziert die Rechnereinrichtung die bestimmungsgemäße Funktion der Verbindungsschaltung in Abhängigkeit der ermittelten anliegenden ersten und zweiten Versorgungsspannung, indem eine Differenz der ermittelten anliegenden ersten und zweiten Versorgungsspannung gebildet und ausgewertet wird oder indem die Zeitpunkte verglichen werden, zu denen die erste und zweite Versorgungsspannung anliegt oder indem eine Kombination der Informationen ausgewertet wird. Bevorzugt diagnostiziert die Rechnereinrichtung einen Defekt der Verbindungsschaltung, wenn die Differenz einen vorgebbaren Differenzschwellwert überschreitet, oder wenn über eine Zeitdauer, die einen vorgebbaren Zeitdauerwert überschreitet, nur eine der anliegenden Versorgungsspannungen anliegt. Bevorzugt wird der Betrieb der ersten Versorgungsquelle oder der Versorgungsschaltung eingestellt, wenn ein Defekt diagnostiziert wird. Vorteilhaft wird eine Versorgungsschaltung bereitgestellt, die eine Diagnose einer Verbindungsschaltung ermöglicht. Bevorzugt wird hierzu keine direkte oder physikalische Verbindung zwischen der Rechnereinheit und der Verbindungsschaltung benötigt. Dies ermöglicht eine besonders einfache Umsetzung in einem Steuergerät.

In einer anderen Ausgestaltung der Erfindung ist die Rechnereinrichtung dazu eingerichtet, die bestimmungsgemäße Funktion der Verbindungsschaltung zu diagnostizieren, wenn zunächst die erste anliegende Versorgungsspannung einem ersten vorgebbaren Spannungswert entspricht und die zweite anliegende Versorgungsspannung einem zweiten vorgebbaren Spanungswert entspricht und nach anschließendem Ablauf der ersten Zeitdauer die zweite anliegende Versorgungsspannung einem dritten vorgebbaren Spannungswert entspricht und insbesondere die erste anliegende Versorgungsspannung dem ersten vorgebbaren Spannungswert entspricht.

Bevorzugt entspricht der zweite Spannungswert Null Volt, da aufgrund der Schaltverzögerung unmittelbar nach dem Bereitstellen der dritten Versorgungsspannung für die Verbindungsschaltung lediglich an dem ersten Verbraucher die erste Versorgungsspannung anliegt und aufgrund des geöffneten Schalters die dritte Versorgungsspannung nicht an dem zweiten Verbraucher anliegt. Bevorzugt beträgt die zweite anliegende Versorgungsspannung am zweiten Verbraucher daher Null Volt, wenn der Schalter bestimmungsgemäß geöffnet ist. Aufgrund der Schaltverzögerung beträgt bevorzugt nach Verstreichen der ersten Zeitdauer die zweite anliegende Versorgungspannung einem dritten Spannungswert, wobei dieser bevorzugt der dritten Versorgungsspannung entspricht, die mittels geschlossenem Schalter der Verbindungsschaltung nun dem zweiten Verbraucher bereitgestellt wird. Bevorzugt entspricht die erste anliegende Versorgungsspannung weiterhin dem ersten vorgebbaren Spannungswert. Bevorzugt wird ein Defekt diagnostiziert, wenn die anliegenden Versorgungsspannungen von den vorgegebenen Spannungswerten abweichen. Bevorzugt wird ein Defekt diagnostiziert, wenn bereits zu Beginn der Diagnose die erste anliegende Versorgungsspannung einem ersten vorgebbaren Spannungswert entspricht und die zweite anliegende Versorgungsspannung dem dritten Spannungswert oder nach Verstreichen der ersten Zeitdauer die zweite anliegende Versorgungspannung dem zweiten Spannungswert entspricht. Bevorzugt wird der Betrieb der ersten Versorgungsquelle oder der Versorgungsschaltung eingestellt, wenn ein Defekt diagnostiziert wird. Vorteilhaft wird eine Versorgungsschaltung bereitgestellt, die eine verbesserte Diagnose der Verbindungsschaltung ermöglicht. Bevorzugt wird eine Diagnose bereitgestellt, die die bestimmungsgemäße Funktion des Schaltelementes sicherstellt. Bevorzugt ist die bestimmungsgemäße Funktion des Schaltelementes, dass es öffnet, wenn die dritte Versorgungsspannung nicht für die Verbindungsschaltung bereitgestellt ist oder solange die erste Zeitdauer der Schaltverzögerungseinrichtung noch nicht verstrichen ist.

In einer anderen Ausgestaltung der Erfindung wird zunächst die erste Versorgungsquelle eingeschaltet und die zweite Versorgungsquelle erst nach Verstreichen der ersten Zeitdauer und einer zweiten vorgebbaren Zeitdauer eingeschaltet.

Die zweite Versorgungsquelle stellt nach dem Einschalten für den zweiten Verbraucher eine zweite Versorgungsspannung bereit. Damit die daraus resultierende anliegende Spannung am zweiten Verbraucher nicht während der Diagnose fehlerhaft als zweite anliegende Versorgungsspannung ermittelt werden kann, wird die zweite Versorgungsquelle erst nach Verstreichen der ersten Zeitdauer nach Einschalten der ersten Versorgungsquelle und einer zweiten vorgebbaren Zeitdauer zugeschaltet. Bevorzugt beträgt die zweite vorgebbare Zeitdauer ungefähr 1 bis 4 Sekunden. Vorteilhaft wird eine Versorgungsschaltung bereitgestellt, die eine verbesserte Diagnose der Verbindungsschaltung ermöglicht.

In einer anderen Ausgestaltung der Erfindung umfasst die Verbindungsschaltung eine Strommesseinrichtung zur Ermittlung eines Laststromes durch das geschlossene Schaltelement. Die Verbindungsschaltung ist weiter dazu eingerichtet, das Schaltelement zu öffnen, wenn der ermittelte Laststrom einen ersten vorgebbaren Stromwert überschreitet.

Bei einem Kurzschluss der zweiten Versorgungsspannung gegen Masse oder ein anderes Potential besteht die Gefahr, dass sich ein sehr großer Laststrom ausbildet, der auch durch die Verbindungsschaltung fließt. Dies führt zu einem Zusammenbrechen der von der ersten Versorgungsquelle bereitgestellten ersten und dritten Versorgungsspannung. Zur Gewährleistung einer weiteren sicheren Versorgung zumindest des ersten Verbrauchers werden die Anschlussleitungen zwischen der ersten Versorgungsquelle und dem zweiten Verbraucher mittels Öffnen des Schaltelementes der Verbindungsschaltung getrennt. Hierzu öffnet die Verbindungsschaltung das Schaltelement, wenn ein ermittelter Laststrom einen ersten vorgebbaren Stromwert überschreitet. Vorteilhaft wird ein sicherer Betrieb einer Versorgungsschaltung mit einer Rechnereinrichtung zur Diagnose einer Verbindungsschaltung gewährleistet, wobei eine eigensichere Verbindungsschaltung bereitgestellt wird.

Ferner betrifft die Erfindung einen Antriebsstrang mit einer Versorgungsschaltung. Ein Antriebsstrang umfasst neben der Versorgungsschaltung bevorzugt eine Batterie zur Versorgung des Antriebsstrangs, einen Wechselrichter zur Wandung der Gleichspannung der Batterie in eine Wechselspannung zur Versorgung einer elektrischen Maschine und oder die elektrische Maschine. Vorteilhaft wird ein Antriebsstrang bereitgestellt, der eine Diagnose einer Verbindungsschaltung ermöglicht.

Ferner betrifft die Erfindung ein Fahrzeug mit einem Antriebsstrang. Ein Fahrzeug kann ein Fahrzeug zu Lande, im Wasser und in der Luft sein, bevorzugt ein Kraftfahrzeug. Vorteilhaft wird ein Fahrzeug bereitgestellt, welches eine Diagnose einer Verbindungsschaltung ermöglicht.

Ferner betrifft die Erfindung ein Verfahren für den Betrieb einer Versorgungsschaltung mit den Schritten: Ermitteln einer anliegenden zweiten Versorgungsspannung an dem zweiten Verbraucher; Diagnostizieren der bestimmungsgemäßen Funktion der Verbindungsschaltung in Abhängigkeit der ermittelten anliegenden zweiten Versorgungsspannung. Vorteilhaft wird ein Verfahren für den Betrieb einer Versorgungsschaltung bereitgestellt, welches eine Diagnose einer Verbindungsschaltung ermöglicht.

Ferner betrifft die Erfindung ein Computerprogramm, umfassend Befehle, die bewirken, dass die Rechnereinrichtung der Versorgungsschaltung die Schritte des Verfahrens ausführt.

Ferner betrifft die Erfindung computerlesbares Medium, umfassend Befehle, die bei der Ausführung durch die Rechnereinrichtung der Versorgungsschaltung diese veranlassen, die Schritte des Verfahrens auszuführen.

Es versteht sich, dass die Merkmale, Eigenschaften und Vorteile der Versorgungsschaltung entsprechend auf das Verfahren bzw. den Antriebsstrang und das Fahrzeug und umgekehrt zutreffen bzw. anwendbar sind.

Weitere Merkmale und Vorteile von Ausführungsformen der Erfindung ergeben sich aus der nachfolgenden Beschreibung mit Bezug auf die beigefügten Zeichnungen.

### Kurze Beschreibung der Zeichnung

Im Folgenden soll die Erfindung anhand einiger Figuren näher erläutert werden, dazu zeigen:
Figur 1
   eine schematische Darstellung einer Versorgungsschaltung mit einer Rechnereinrichtung zur Diagnose einer Verbindungsschaltung.
Figur 2
   ein schematisch dargestelltes Fahrzeug mit einem Antriebsstrang mit einer Versorgungsschaltung,
Figur 3
   ein schematisch dargestelltes Verfahren für den Betrieb einer Versorgungsschaltung.

### Ausführungsformen der Erfindung

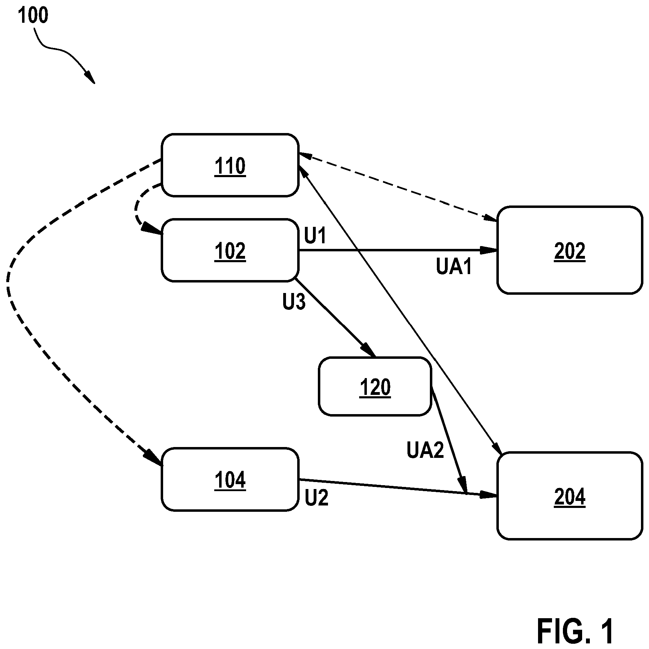

Die Figur 1 zeigt eine Versorgungsschaltung 100 mit einer Rechnereinrichtung 110 zur Diagnose einer Verbindungsschaltung 120. Die Versorgungsschaltung 100 umfasst eine erste und eine zweite Versorgungsquelle 102, 104 zur Versorgung eines ersten und eines zweiten Verbrauchers 202, 204. Die erste Versorgungsquelle 102 ist dazu eingerichtet, nach einem Einschalten der ersten Versorgungsquelle eine erste Versorgungsspannung U1 für den ersten Verbraucher 202 bereitzustellen und eine dritte Versorgungsspannung U3 für die Verbindungsschaltung 120 bereitzustellen. Die dritte Versorgungsspannung U3 kann mittels der Verbindungsschaltung 120 auch dem zweiten Verbraucher 204 bereitgestellt werden. Die zweite Versorgungsquelle 104 ist dazu eingerichtet, nach dem Einschalten der zweiten Versorgungsquelle eine zweite Versorgungsspannung U2 für den zweiten Verbraucher 204 bereitzustellen. Die Verbindungsschaltung 120 ist dazu eingerichtet ist, mittels Schließen eines Schaltelementes die dritte Versorgungsspannung U3 mit dem zweiten Verbraucher 204 elektrisch zu verbinden und mittels Öffnen des Schaltelementes die dritte Versorgungsspannung U3 von dem zweiten Verbraucher 204 zu trennen. Die Versorgungsschaltung 100 umfasst eine Rechnereinrichtung 110. Bevorzugt ist die Rechnereinrichtung 110 dazu eingerichtet, die erste und oder zweite Versorgungsquelle 102, 104 einzuschalten. Die Rechnereinrichtung 110 ist dazu eingerichtet, eine anliegende zweite Versorgungsspannung UA2 am zweiten Verbraucher 204 zu ermitteln. Bevorzugt ist die Rechnereinrichtung 110 dazu eingerichtet, eine anliegende erste Versorgungsspannung UA1 am ersten Verbraucher 202 zu ermitteln. Weiter ist die Rechnereinrichtung 110 dazu eingerichtet, die bestimmungsgemäße Funktion der Verbindungsschaltung 120 in Abhängigkeit der ermittelten anliegenden zweiten und oder ersten Versorgungsspannung UA1, UA2 zu diagnostizieren.

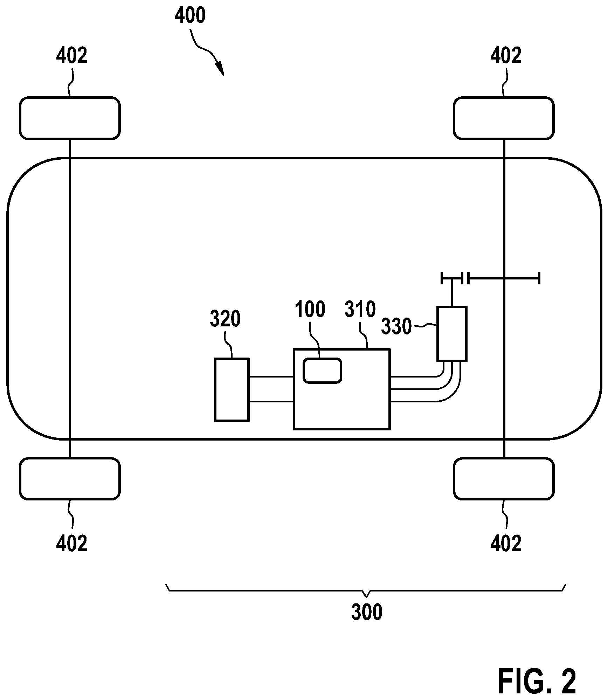

Figur 2 zeigt ein schematisch dargestelltes Fahrzeug 400 mit vier Rädern 402 und einem Antriebsstrang 300. Das Fahrzeug 400 ist hier nur beispielhaft mit vier Rädern 402 dargestellt, wobei die Erfindung gleichermaßen in beliebigen Fahrzeugen mit einer beliebigen Anzahl an Rädern zu Lande, zu Wasser und in der Luft einsetzbar ist. Der beispielhaft dargestellte Antriebsstrang 300 umfasst eine Versorgungsschaltung 100, die bevorzugt in einen Wechselrichter 310 integriert ist. Der Antriebsstrang 300 umfasst bevorzugt eine Batterie 320, einen Wechselrichter 310 und oder eine elektrische Maschine 330.

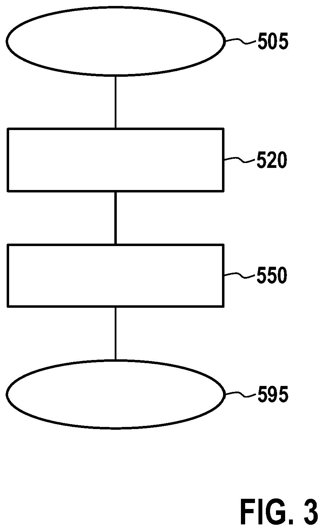

Figur 3 zeigt ein schematisch dargestelltes Ablaufdiagramm für ein Verfahren 500 für den Betrieb einer Versorgungsschaltung 100. Das Verfahren beginnt mit Schritt 505. In Schritt 520 wird eine anliegende zweite Versorgungsspannung UA2 an dem zweiten Verbraucher 204 ermittelt. In Schritt 550 wird die bestimmungsgemäße Funktion der Verbindungsschaltung 120 in Abhängigkeit der ermittelten anliegenden zweiten Versorgungsspannung UA2 diagnostiziert. Mit Schritt 595 endet das Verfahren.

## Patentansprüche

1. Versorgungsschaltung (100) mit einer Rechnereinrichtung (110) zur Diagnose einer Verbindungsschaltung (120), insbesondere für eine Leistungselektronik in einem Fahrzeug,
wobei die Versorgungsschaltung (100) eine erste und eine zweite Versorgungsquelle (102, 104) umfasst zur Versorgung eines ersten und eines zweiten Verbrauchers (202, 204),
wobei die erste Versorgungsquelle (102) dazu eingerichtet ist, nach dem Einschalten der ersten Versorgungsquelle (102) eine erste Versorgungsspannung (U1) für den ersten Verbraucher (202) bereitzustellen und eine dritte Versorgungsspannung (U3) für die Verbindungsschaltung (120) bereitzustellen, wobei die dritte Versorgungsspannung mittels der Verbindungsschaltung (120) auch dem zweiten Verbraucher (204) bereitstellbar ist,
wobei die zweite Versorgungsquelle (104) dazu eingerichtet ist, nach dem Einschalten der zweiten Versorgungsquelle (104) eine zweite Versorgungsspannung (U2) für den zweiten Verbraucher (204) bereitzustellen,
wobei die Verbindungsschaltung (120) ein Schaltelement umfasst und dazu eingerichtet ist, mittels Schließen des Schaltelementes die dritte Versorgungsspannung (U3) mit dem zweiten Verbraucher (204) elektrisch zu verbinden und mittels Öffnen des Schaltelementes die dritte Versorgungsspannung (U3) von dem zweiten Verbraucher (204) zu trennen, wobei die Versorgungsschaltung (100) eine Rechnereinrichtung (110) umfasst und
**dadurch gekennzeichnet, dass**
die Rechnereinrichtung (110) dazu eingerichtet ist,
eine anliegende zweite Versorgungsspannung (UA2) am zweiten Verbraucher (204) zu ermitteln,
und die bestimmungsgemäße Funktion der Verbindungsschaltung (120) in Abhängigkeit der ermittelten anliegenden zweiten Versorgungsspannung (UA2) zu diagnostizieren.

2. Versorgungsschaltung nach Anspruch 1,
wobei das Schaltelement der Verbindungsschaltung (120) geöffnet ist, solange die dritte Versorgungsspannung (U3) nicht an der Verbindungsschaltung (120) anliegt.

3. Versorgungsschaltung nach einem der vorhergehenden Ansprüche,
wobei die Verbindungsschaltung (120) eine Schaltverzögerungseinrichtung umfasst und dazu eingerichtet ist, das Schaltelement nach einer vorgebbaren ersten Zeitdauer zu schließen, nachdem die dritte Versorgungsspannung (U3) an der Verbindungsschaltung (120) anliegt.

4. Versorgungsschaltung nach Anspruch 3,
wobei die Rechnereinrichtung (110) dazu eingerichtet ist, die erste Versorgungsquelle (102) einzuschalten und die bestimmungsgemäße Funktion der Verbindungsschaltung (120) zu diagnostizieren, wenn bei Ablauf einer vorgebbaren Einschaltdauer nach dem Einschalten der ersten Versorgungsquelle die zweite anliegende Versorgungsspannung (UA2) einem zweiten vorgebbaren Spanungswert (US2) entspricht und nach anschließendem Ablauf der ersten Zeitdauer die zweite anliegende Versorgungsspannung (UA2) einem dritten vorgebbaren Spanungswert (US3) entspricht.

5. Versorgungsschaltung nach einem der Ansprüche 1 bis 3, wobei die Rechnereinrichtung dazu eingerichtet ist, eine anliegende erste Versorgungsspannung (UA1) am ersten Verbraucher (202) zu ermitteln, und die bestimmungsgemäße Funktion der Verbindungsschaltung (120) in Abhängigkeit der ermittelten anliegenden ersten und zweiten Versorgungsspannung (UA1, UA2) zu diagnostizieren.

6. Versorgungsschaltung nach Anspruch 5,
wobei die Rechnereinrichtung (110) dazu eingerichtet ist, die bestimmungsgemäße Funktion der Verbindungsschaltung (120) zu diagnostizieren, wenn zunächst die erste anliegende Versorgungsspannung (UA1) einem ersten vorgebbaren Spannungswert (US1) entspricht und die zweite anliegende Versorgungsspannung (UA2) einem zweiten vorgebbaren Spanungswert (US2) entspricht
und nach anschließendem Ablauf der ersten Zeitdauer die zweite anliegende Versorgungsspannung (UA2) einem dritten vorgebbaren Spanungswert (US3) entspricht und insbesondere die erste anliegende Versorgungsspannung (UA1) dem ersten vorgebbaren Spannungswert (US1) entspricht.

7. Versorgungsschaltung nach einem der vorhergehenden Ansprüche,
wobei zunächst die erste Versorgungsquelle (102) eingeschaltet wird und die zweite Versorgungsquelle (104) erst nach Verstreichen der ersten Zeitdauer und einer zweiten vorgebbaren Zeitdauer eingeschaltet wird.

8. Versorgungsschaltung nach einem der vorhergehenden Ansprüche, wobei die Verbindungsschaltung (120) eine Strommesseinrichtung zur Ermittlung eines Laststromes durch das geschlossene Schaltelement umfasst und dazu eingerichtet ist, das Schaltelement zu öffnen, wenn der ermittelte Laststrom einen ersten vorgebbaren Stromwert überschreitet.

9. Antriebsstrang (300) eines Fahrzeugs mit einer Versorgungsschaltung (100) nach einem der vorhergehenden Ansprüche.

10. Fahrzeug (400) mit einem Antriebsstrang (300) nach Anspruch 9.

11. Verfahren (500) für den Betrieb einer Versorgungsschaltung (100), insbesondere für eine Leistungselektronik in einem Fahrzeug, nach einem der vorhergehenden Ansprüche mit den Schritten;
- Ermitteln (520) einer anliegenden zweiten Versorgungsspannung (UA2) an dem zweiten Verbraucher (204);
- Diagnostizieren (550) der bestimmungsgemäßen Funktion der Verbindungsschaltung (120) in Abhängigkeit der ermittelten anliegenden zweiten Versorgungsspannung (UA1, UA2).

12. Computerprogramm, umfassend Befehle, die bewirken, dass die Rechnereinrichtung (110) der Versorgungsschaltung (100) nach einem der Ansprüche 1 bis 10 die Schritte des Verfahrens nach Anspruch 11 ausführt.

13. Computerlesbares Medium, umfassend Befehle, die bei der Ausführung durch die Rechnereinrichtung (110) der Versorgungsschaltung (100) nach einem der Ansprüche 1 bis 10 diese veranlassen, die Schritte des Verfahrens (500) nach Anspruch 11 auszuführen.

## Claims

1. Supply circuit (100) having a computer device (110) for diagnosing a connection circuit (120), in particular for a power electronics system in a vehicle,
wherein the supply circuit (100) comprises a first and a second supply source (102, 104) for supplying a first and a second consumer (202, 204),
wherein the first supply source (102) is configured to provide a first supply voltage (U1) for the first consumer (202) after the first supply source (102) has been switched on and to provide a third supply voltage (U3) for the connection circuit (120), wherein the third supply voltage can also be provided to the second consumer (204) by means of the connection circuit (120),
wherein the second supply source (104) is configured to provide a second supply voltage (U2) for the second consumer (204) after the second supply source (104) has been switched on,
wherein the connection circuit (120) comprises a switching element and is configured to electrically connect the third supply voltage (U3) to the second consumer (204) by means of closing the switching element and to disconnect the third supply voltage (U3) from the second consumer (204) by means of opening the switching element, wherein the supply circuit (100) comprises a computer device (110) and
**characterized in that**
the computer device (110) is configured
to determine an applied second supply voltage (UA2) at the second consumer (204),
and to diagnose the correct operation of the connection circuit (120) according to the determined applied second supply voltage (UA2).

2. Supply circuit according to Claim 1,
wherein the switching element of the connection circuit (120) is open as long as the third supply voltage (U3) is not applied to the connection circuit (120).

3. Supply circuit according to either one of the preceding claims,
wherein the connection circuit (120) comprises a switching delay device and is configured to close the switching element after a specifiable first time period once the third supply voltage (U3) is applied to the connecting circuit (120).

4. Supply circuit according to Claim 3,
wherein the computer device (110) is configured to switch on the first supply source (102) and to diagnose the correct operation of the connection circuit (120) if, on expiry of a specifiable switch-on duration after the first supply source has been switched on, the second applied supply voltage (UA2) corresponds to a second specifiable voltage value (US2)
and, after subsequent expiry of the first time period, the second applied supply voltage (UA2) corresponds to a third specifiable voltage value (US3).

5. Supply circuit according to any one of Claims 1 to 3, wherein the computer device is configured to determine an applied first supply voltage (UA1) at the first consumer (202), and to diagnose the correct operation of the connection circuit (120) on the basis of the determined applied first and second supply voltage (UA1, UA2).

6. Supply circuit according to Claim 5,
wherein the computer device (110) is configured to diagnose the correct operation of the connection circuit (120) if initially the first applied supply voltage (UA1) corresponds to a first specifiable voltage value (US1) and the second applied supply voltage (UA2) corresponds to a second specifiable voltage value (US2)
and, after subsequent expiry of the first time period, the second applied supply voltage (UA2) corresponds to a third specifiable voltage value (US3) and, in particular, the first applied supply voltage (UA1) corresponds to the first specifiable voltage value (US1).

7. Supply circuit according to either one of the preceding claims,
wherein the first supply source (102) is switched on first and the second supply source (104) is switched on only after the first time period and a second specifiable time period have elapsed.

8. Supply circuit according to any one of the preceding claims, wherein the connection circuit (120) comprises a current measuring device for determining a load current through the closed switching element and is configured to open the switching element if the determined load current exceeds a first specifiable current value.

9. Drive train (300) of a vehicle having a supply circuit (100) according to any one of the preceding claims.

10. Vehicle (400) having a drive train (300) according to Claim 9.

11. Method (500) for operating a supply circuit (100), in particular for a power electronics system in a vehicle, according to any one of the preceding claims, having the following steps:
- determining (520) an applied second supply voltage (UA2) at the second consumer (204);
- diagnosing (550) the correct operation of the connection circuit (120) according to the determined applied second supply voltage (UA1, UA2).

12. Computer program comprising instructions which cause the computer device (110) of the supply circuit (100) according to any one of Claims 1 to 10 to execute the steps of the method according to Claim 11.

13. Computer-readable medium comprising instructions which, when executed by the computer device (110) of the supply circuit (100) according to any one of Claims 1 to 10, cause the computer device to execute the steps of the method (500) according to Claim 11.

## Revendications

1. Circuit d'alimentation (100) comprenant un dispositif informatique (110) pour diagnostiquer un circuit de connexion (120), en particulier pour l'électronique de puissance dans un véhicule,
le circuit d'alimentation (100) comprenant une première et une deuxième source d'alimentation (102, 104) pour fournir de la puissance à une première et à une deuxième charge (202, 204),
la première source d'alimentation (102) étant configurée pour fournir, après la mise sous tension de la première source d'alimentation (102), une première tension d'alimentation (U1) à la première charge (202) et pour fournir une troisième tension d'alimentation (U3) au circuit de connexion (120), la troisième tension d'alimentation pouvant également être fournie à la deuxième charge (204) par l'intermédiaire du circuit de connexion (120),
la deuxième source d'alimentation (104) étant configurée pour fournir, après la mise sous tension de la deuxième source d'alimentation (104), une deuxième tension d'alimentation (U2) à la deuxième charge (204),
le circuit de connexion (120) comprenant un élément de commutation et étant configuré pour relier électriquement la troisième tension d'alimentation (U3) à la deuxième charge (204) en fermant l'élément de commutation et pour séparer la troisième tension d'alimentation (U3) de la deuxième charge (204) en ouvrant l'élément de commutation, le circuit d'alimentation (100) comprenant un dispositif informatique (110) et
**caractérisé en ce que**
le dispositif informatique (110) est configuré pour
déterminer une deuxième tension d'alimentation appliquée (UA2) à la deuxième charge (204),
et pour diagnostiquer le fonctionnement correct du circuit de connexion (120) sur la base de la deuxième tension d'alimentation appliquée (UA2) déterminée.

2. Circuit d'alimentation selon la revendication 1,
dans lequel l'élément de commutation du circuit de connexion (120) est ouvert tant que la troisième tension d'alimentation (U3) n'est pas appliquée au circuit de connexion (120).

3. Circuit d'alimentation selon l'une des revendications précédentes,
dans lequel le circuit de connexion (120) comprend un dispositif de temporisation de commutation et est configuré pour fermer l'élément de commutation après une première durée pouvant être prédéterminée, après que la troisième tension d'alimentation (U3) a été appliquée au circuit de connexion (120).

4. Circuit d'alimentation selon la revendication 3,
dans lequel le dispositif informatique (110) est configuré pour mettre sous tension la première source d'alimentation (102) et pour diagnostiquer le fonctionnement correct du circuit de connexion (120) si, à l'issue d'une durée de mise sous tension pouvant être prédéterminée après la mise sous tension de la première source d'alimentation, la deuxième tension d'alimentation appliquée (UA2) correspond à une deuxième valeur de tension pouvant être prédéterminée (US2)
et si, à l'issue de l'écoulement ultérieur de la première durée, la deuxième tension d'alimentation appliquée (UA2) correspond à une troisième valeur de tension pouvant être prédéterminée (US3).

5. Circuit d'alimentation selon l'une des revendications 1 à 3, dans lequel le dispositif informatique est configuré pour déterminer une première tension d'alimentation appliquée (UA1) à la première charge (202), et pour diagnostiquer le fonctionnement correct du circuit de connexion (120) sur la base de la première et de la deuxième tension d'alimentation appliquée (UA1, UA2) déterminées.

6. Circuit d'alimentation selon la revendication 5,
dans lequel le dispositif informatique (110) est configuré pour diagnostiquer le fonctionnement correct du circuit de connexion (120) si, en premier lieu, la première tension d'alimentation appliquée (UA1) correspond à une première valeur de tension pouvant être prédéterminée (US1) et la deuxième tension d'alimentation appliquée (UA2) correspond à une deuxième valeur de tension pouvant être prédéterminée (US2)
et si, à l'issue de l'écoulement ultérieur de la première durée, la deuxième tension d'alimentation appliquée (UA2) correspond à une troisième valeur de tension pouvant être prédéterminée (US3) et si, en particulier, la première tension d'alimentation appliquée (UA1) correspond à la première valeur de tension pouvant être prédéterminée (US1).

7. Circuit d'alimentation selon l'une des revendications précédentes,
dans lequel, en premier lieu, la première source d'alimentation (102) est mise sous tension et la deuxième source d'alimentation (104) n'est mise sous tension qu'après l'écoulement de la première durée et d'une deuxième durée pouvant être prédéterminée.

8. Circuit d'alimentation selon l'une des revendications précédentes, dans lequel le circuit de connexion (120) comprend un dispositif de mesure de courant pour la détermination d'un courant de charge à travers l'élément de commutation fermé et est configuré pour ouvrir l'élément de commutation si le courant de charge déterminé dépasse une première valeur de courant pouvant être prédéterminée.

9. Chaîne cinématique (300) d'un véhicule, comprenant un circuit d'alimentation (100) selon l'une des revendications précédentes.

10. Véhicule (400), comprenant une chaîne cinématique (300) selon la revendication 9.

11. Procédé (500) pour le fonctionnement d'un circuit d'alimentation (100), en particulier pour l'électronique de puissance dans un véhicule, selon l'une des revendications précédentes, comprenant les étapes suivantes :
- détermination (520) d'une deuxième tension d'alimentation appliquée (UA2) à la deuxième charge (204) ;
- diagnostic (550) du fonctionnement correct du circuit de connexion (120) sur la base de la deuxième tension d'alimentation appliquée (UA1, UA2) déterminée.

12. Programme informatique, comprenant des instructions qui amènent le dispositif informatique (110) du circuit d'alimentation (100) selon l'une des revendications 1 à 10 à exécuter les étapes du procédé selon la revendication 11.

13. Support lisible par ordinateur, comprenant des instructions qui, lors de leur exécution par le dispositif informatique (110) du circuit d'alimentation (100) selon l'une des revendications 1 à 10, l'amènent à exécuter les étapes du procédé (500) selon la revendication 11.
